(19) Europäisches Patentamt

European Patent Office

Office européen des brevets

(11) EP 1 337 041 A1

(12) EUROPEAN PATENT APPLICATION

(43) Date of publication:
20.08.2003 Bulletin 2003/34

(51) Int Cl.⁷: H03J 1/00

(21) Application number: 02023916.6

(22) Date of filing: 24.10.2002

(84) Designated Contracting States:
AT BE BG CH CY CZ DE DK EE ES FI FR GB GR
IE IT LI LU MC NL PT SE SK TR
Designated Extension States:
AL LT LV MK RO SI

(30) Priority: 14.02.2002 JP 2002036767

(71) Applicant: MITSUBISHI DENKI KABUSHIKI
KAISHA
Tokyo 100-8310 (JP)

(72) Inventor: Sako, Takumi, c/o Mitsubishi Denki K. K.
Tokyo 100-8310 (JP)

(74) Representative: Sajda, Wolf E., Dipl.-Phys. et al
MEISSNER, BOLTE & PARTNER
Widenmayerstrasse 48
80538 München (DE)

(54) **Frequency selection method and receiver**

(57)     In a mobile communication device, in order to reduce power consumed by searching for accessible base stations, the band search processing time is reduced. Thus the time required from the moment the mobile communication device is powered-on to the completion of a searching action is to be reduced.

The predetermined frequency band of base station channels is divided into groups in ascending frequency order. The number of frequencies in each of the groups is smaller than the number of frequencies constituting the predetermined frequency band.

A single frequency is set as a representative frequency in each group. It is checked whether the representative frequency of each group satisfies a first condition on the basis of a received signal strength indicator (S11). If it does, all the frequencies in this group are checked whether they satisfy a second condition on the basis of the received signal strength indicator (S14).

F I G. 3

```
        BAND SEARCH PROCESSING
                  |
        CHECK REPRESENTATIVE          S11
              FREQUENCY
                  |
        SELECT ONE OF CHECKED         S12
     REPRESENTATIVE FREQUENCIES
                  |
              OBTAINED              S13
     NO      RSSI IS NOT LESS
     ----   THAN ITS THRESHOLD
                VALUE ?
                  | YES
        CHECK ALL FREQUENCIES IN      S14
        GROUP TO WHICH SELECTED
        REPRESENTATIVE FREQUENCY
        BELONGS
                  |
                S13 IS               S15
     NO     PERFORMED TO ALL
     ----    REPRESENTATIVE
              FREQUENCIES ?
                  | YES
                 END
```

Printed by Jouve, 75001 PARIS (FR)

**Description**

## BACKGROUND OF THE INVENTION

Field of the Invention

The present invention relates to a method of selecting one or more frequencies from plural different frequencies. This invention is applicable to for example band search processing in mobile communication.

Description of the Background Art

In mobile communication, plural different frequencies constituting a predetermined frequency band are used as a sending frequency of a base station (i.e., a receiving frequency of a mobile communication device). On these frequencies, the base station sends effective waves, which are effective radio waves. For instance, in a 3GPP (3rd generation partnership project) that is a standard of W-CDMA (wideband code division multiple access) method, the effective waves are sent on the frequencies selected from 299 frequencies, which are set at intervals of 200 kHz between 2110 MHz and 2170 MHz, except for 2110 MHz and 2170 MHz.

The mobile communication device checks, when power is applied thereto, where effective waves are located or absence of effective waves in these frequencies. This is called "band search processing." Even when the mobile communication device is located outside the area, it tries to search for any accessible base station by performing band search processing at predetermined time intervals.

The conventional band search processing is time-consuming because it sequentially searches for effective waves on predetermined many frequencies. Therefore, the band search processing at the time of power-on requires much time from the power-on to the completion of acceptance. Particularly, the band search processing performed outside the area causes an increase in power consumption.

With respect to frequencies whose received signal strength indicators are measured to be low due to accidental factor, e.g., phasing, the reliability of the decision of the effective wave search is low. Therefore, the difficulty comes in accurately deciding whether these frequencies include effective waves.

## SUMMARY OF THE INVENTION

The present invention aims at solving the above disadvantages and has its first object to suppress power consumed outside the area by reducing band search processing time thereby to reduce the time required from the power-on to the completion of acceptance. The invention also has its second object to accurately detect effective waves, if any, on radio waves of received signal whose strength indictor is lowered due to accidental factor.

A first aspect of the present invention is intended for a frequency selection method of selecting at least one of plural frequencies constituting a predetermined frequency band. The plural frequencies are divided into plural groups adjacent each other in their ascending order. At least one representative frequency is present among the plural frequencies constituting each of the groups. According to the present invention, the method includes the following steps (a) and (b). The step (a) is to obtain the representative frequency satisfying a first condition on the basis of a received signal strength indicator. The step (b) is to select at least one of the frequencies satisfying a second condition on the basis of the power of a desired wave, from all of the frequencies constituting each of the groups to which the representative frequency satisfying the first condition belongs.

Firstly, group selection is performed based on the first condition, and frequency selection is performed with respect to the selected groups based on the second condition. This permits a rapid and low electric power selection.

Preferably, the first condition is the fact that the received signal strength indicator is absolutely or relatively higher than a predetermined level.

In the frequencies constituting a predetermined frequency band, high received signal strength indicator is obtained in the frequency band in the vicinity of the frequency on which an effective wave is present. The decision based on the second condition is performed only with respect to the groups having a high possibility of the presence of effective waves.

A second aspect of the present invention is intended for a frequency selection method of selecting at least one of plural different frequencies constituting a predetermined frequency band. According to the present invention, the method includes the following steps (a) and (b). The step (a) is to, when an index on the basis of a received power with respect to one of the frequencies is not less than a predetermined value below the index with respect to the other adjacent to the one frequency, find again the index with respect to the one frequency. The step (b) is to, from the frequencies satisfying a first condition on the basis of the fact that the index is not less than a predetermined value, select frequencies satisfying a second condition on the basis of the power of a desired wave.

With respect to frequencies having a small index, the reliability of the selection based on the second condition is low even though it is caused by any accidental factor such as phasing. Therefore, the frequencies whose index is below a predetermined value cannot be used as the object to be decided based on the second condition. However, it is possible to recover the frequencies whose index has been measured to be low, by finding their indexes again. As the result, these frequencies can serve as the object to be decided based on the second condition in the step (b). This avoids failing to select frequencies due to any accidental factor.

These and other objects, features, aspects and advantages of the present invention will become more apparent from the following detailed description of the present invention when taken in conjunction with the accompanying drawings.

## BRIEF DESCRIPTION OF THE DRAWINGS

Fig. 1 is a block diagram showing the configuration of a mobile communication device to which a first preferred embodiment of the invention is applicable;

Fig. 2 is a conceptual diagram showing an example of grouping in the first preferred embodiment;

Fig. 3 is a flowchart showing a band search processing in the first preferred embodiment;

Fig. 4 is a graph showing the values of received signal strength indicators to the respective frequencies;

Fig. 5 is a graph showing the received signal strength indicators when receiving a predetermined frequency band; and

Fig. 6 is a flowchart showing a band search processing in a second preferred embodiment of the invention.

## DESCRIPTION OF THE PREFERRED EMBODIMENTS

### First Preferred Embodiment

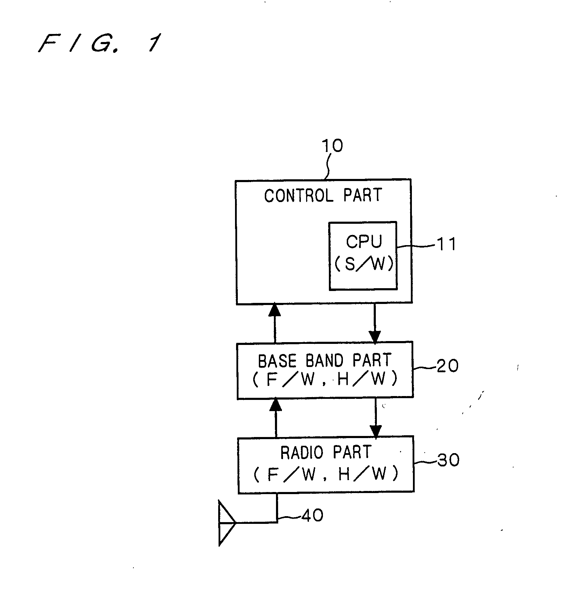

The invention for achieving the first object is mainly described in a first preferred embodiment of the present invention. Fig. 1 is a block diagram showing the configuration of a mobile communication device to which the first preferred embodiment is applicable. The communication mobile device comprises a control part 10, base band part 20, radio part 30, and antenna 40. The control part 10 controls the entire device operation. The base band part 20 synthesizes/separates voice signals and control signals. The radio part 30 modulates/ demodulates radio signals. This mobile communication device is operated for example in accordance with W-CDMA method.

Specifically, band search processing is the following processing that hardware and firmware in the base band part 20 and radio part 30 check the presence or absence of a primary synchronization channel (pSCH) with respect to different frequencies constituting a predetermined frequency band for sending and receiving. The above processing performed by the base band part 20 and radio part 30 are controlled by the software of a CPU 11 in the control part 10.

The presence or absence of the primary synchronization channel on a certain frequency is checked as follows. The base band part 20 measures the received signal strength indicator (RSSI) and the received signal code power (RSCP) of a primary synchronization channel on this frequency. The CPU 11 reduces the received signal strength indicator from the received signal code power, thereby obtaining a difference therebetween. The received signal strength indicator represents the total power also including noise in the aimed frequency band and the waves spread by other scrambling code. Since both of the received signal strength indicator and received signal code power are expressed in logarithm, the difference therebetween is a ratio of power Ec of the wave spread by the desired scrambling code (i.e., the desired wave) to the total power Io on the aimed frequency, that is, Ec/Io. It is recognized that effective waves are present on the frequencies having an Ec/Io higher than a predetermined value.

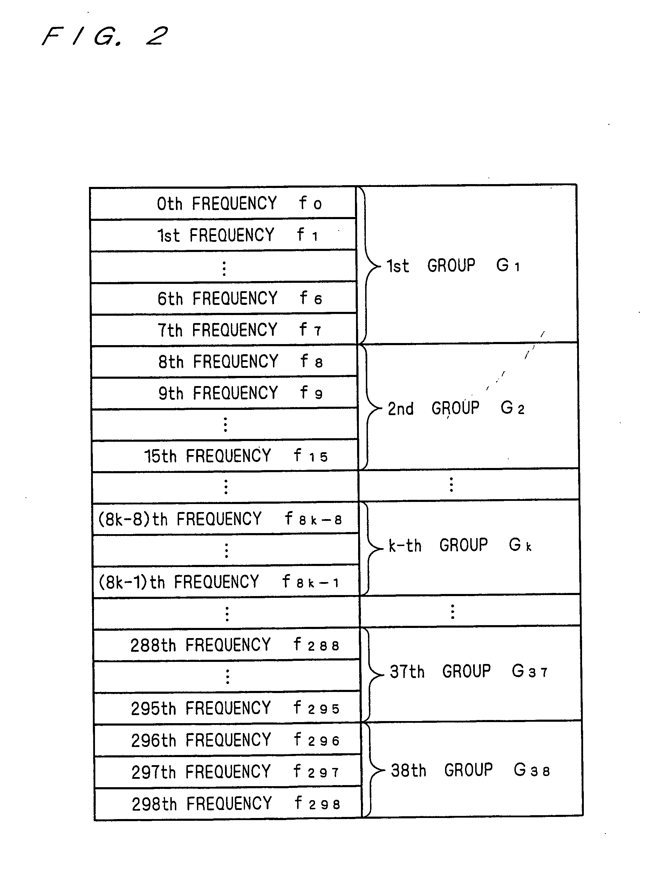

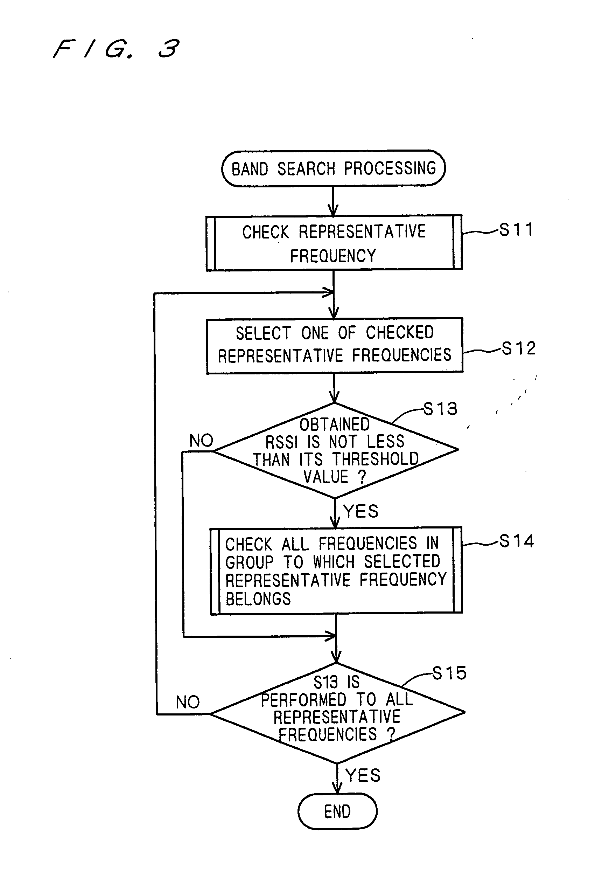

In the first preferred embodiment, frequencies adjacent each other in their ascending order in a predetermined frequency band are divided into groups. The number of frequencies constituting each of the groups is smaller than the number of frequencies constituting the predetermined frequency band. Fig. 2 is a conceptual diagram showing an example of the grouping. In Fig. 2, a predetermined frequency band is composed of the zero-th frequency $f_0$ to the 298th frequency $f_{298}$, and the value of the frequency increases in this order. The (8k-8) frequency $f_{8k-8}$ to the (8k-1) frequency $f_{8k-1}$ (k=1, 2, ... , 37) belong to the k-th group $G_k$. The 296th frequency to the 298th frequency belong to the 38th group $G_{38}$.

There are representative frequencies $F_k$ of not less than one and less than eight that is the number of frequencies constituting each group $G_k$. For example, a single frequency is present as a representative frequency $F_k$. For example, the (8k-5)th frequency $f_{8k-5}$ is present as the representative frequency $F_k$ of the k-th group $G_k$. In the 38th group $G_{38}$, there are representative frequencies of less than three which is the number of frequencies constituting this group, and a single frequency is for example present as a representative frequency $F_{38}$. For example, the 297th frequency $f_{297}$ is selected as the representative frequency $F_{38}$.

Although the presence of the groups and representative frequency are prerequisite in this invention, it is not essential to perform grouping and representative frequency selection. The present invention is applicable to for example the circumstances that a predetermined frequency band is already obtained by dividing frequencies into groups and selecting a representative frequency of each of the groups.

Then, it is decided whether the representative frequencies $F_1$ to $F_{38}$ satisfy a first condition on the basis of a received signal strength indicator. From all the frequencies in the group to which the representative frequency satisfying the first condition belongs, there is selected at least one that satisfies a second condition on the basis of the power of the desired wave.

The first condition is for example the fact that the received signal strength indicator is relatively or absolutely higher than a predetermined electric field level. In the frequencies constituting a predetermined frequency band, high received signal strength indicator is obtained in a frequency band in the vicinity of the frequency on which an effective wave is present, e.g., before and after 2.5 MHz (5 MHz in total). Accordingly, it can be considered that the effective waves are present in the group including the representative frequency having a received signal strength indicator higher than the predetermined electric field level. From this group, frequencies are selected based on the second condition, thereby increasing the speed of band search processing.

The second condition is for example the fact that a difference obtained by reducing a received signal strength indicator from a received signal code power, i. e., the ratio of the received energy per PN chip to a total received power, is higher than a predetermined value. Specifically, when the power ratio, Ec/Io, is higher than the predetermined value, it can be considered that the effective waves are present on the target frequency.

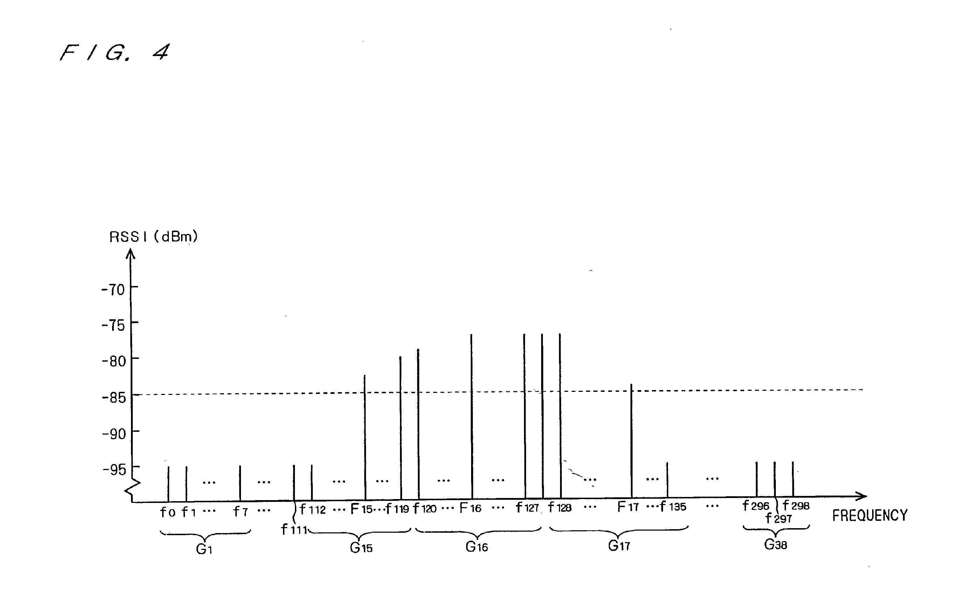

Fig. 3 is a flowchart showing an example of band search processing in the first preferred embodiment. In step S11, representative frequencies $F_1$ to $F_{38}$ are checked. In step S11, at least check based on the first condition is performed, and check based on the second condition may also be performed.

In step S12, the representative frequencies processed in step S11 are selected one by one. In step S13, it is decided whether the received signal strength indicator (RSSI) obtained in step S11 is not less than its threshold value. When a positive decision is obtained, it goes to step S14 and checks all the frequencies in the group to which the representative frequency is belongs. In step S14, at least check based on the second condition is performed, and check based on the first condition may also be performed. Then, it goes to step S15. Even when a negative decision is obtained in step S13, it goes to step S15.

In step S15, it is decided whether step S13 is performed with respect to all the representative frequencies. If a negative decision is obtained, it returns to step S12. If a positive decision is obtained, the band search processing is terminated.

For instance, when the representative frequencies $F_{15}$, $F_{16}$, and $F_{17}$ satisfy the first condition, step S14 is performed with respect to all the frequencies of the groups $G_{15}$, $G_{16}$, and $G_{17}$, namely, the 112th frequency $f_{112}$ to the 135th frequency $f_{135}$.

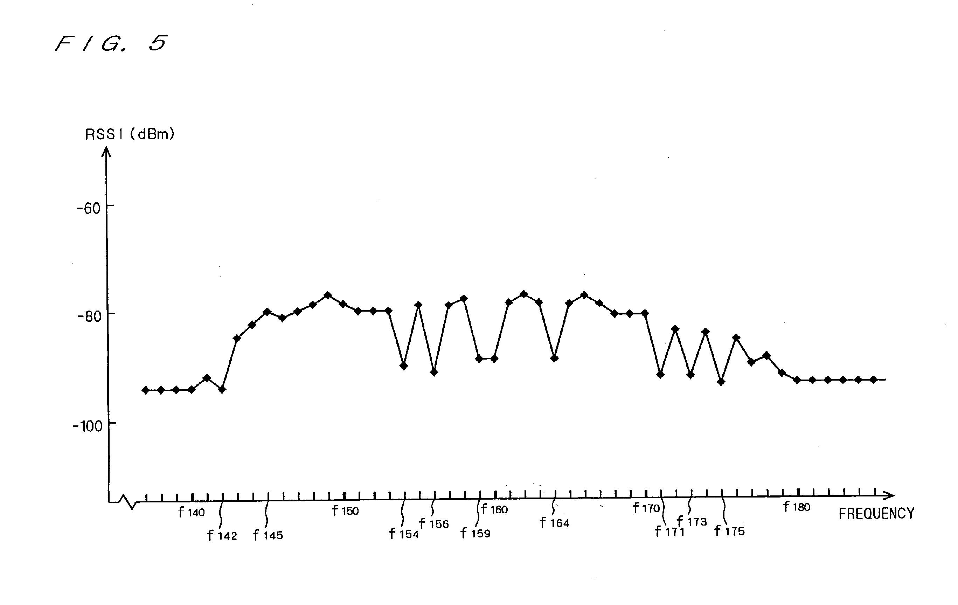

Fig. 4 is a graph showing the values of received signal strength indicators (RSSIs) to the respective frequencies. For instance, the frequencies on which effective waves are present have received signal strength indicators of about -77 dBm, and the frequencies spaced apart by not less than 2.5 MHz from the frequency on which effective waves are present have received signal strength indictors of approximately -95 dBm. Therefore, -85 dBm is set as a predetermined electric field level, which is the criterion of the first condition. This value is obtained by reducing a relative threshold value 8 dB from -77 dBm that is the best result obtained in the check of the representative frequencies. Specifically, Fig. 4 shows the instance that all the representative frequencies $F_{15}$, $F_{16}$, and $F_{17}$, which belong to the groups $G_{15}$, $G_{16}$, and $G_{17}$, respectively, have a value higher than -85 dBm.

As previously described, high received signal strength indicator is obtained before and after 2.5 MHz around the frequency on which an effective wave is present. The distribution to frequencies shows a tendency of a received signal strength indicator to be smaller as the frequency the received signal strength indicator thereon is apart from the frequency on which the effective wave is present. Therefore, when employing, as a representative frequency, the lowest or highest frequency of the group to which the representative frequency belongs, the frequency on which an effective wave is present might be overlooked. In the example of Fig. 4, the 112th frequency $f_{112}$ that is the lowest in the group $G_{15}$ is lower than a predetermined electric field level. Therefore, if the 112th frequency $f_{112}$ is selected as the representative frequency $F_{15}$, even though effective waves are present in the group $G_{15}$, they might be overlooked. In contrast, if the 135th frequency $f_{135}$ is selected as the representative frequency $G_{17}$, even though effective waves are present in the group $G_{17}$, they might be overlooked. Hence, it is desirable that a representative frequency be selected from the vicinity of the median of frequencies in the group to which the representative frequency belongs.

Following is the advantage of the first preferred embodiment when the decisions based on the first and second conditions, namely, the examinations of received signal strength indicators and power ratio Ec/Io, are performed in both of the checks in step S11 and S14. Assume that 30 ms per frequency is necessary in these checks. In the conventional band search processing, the time required only for the checks is found to be 8.97 seconds from the following equation (1), wherein the time of frequency scanning is ignored. Assume that the current consumed in the band search processing is 150 mA. The sum of the electric current is found to be 1345.5 mA · sec by the following equation (2).

$$299 \times 30 \text{ (ms)} = 8.97 \text{ (s)} \qquad (1)$$

$$150 \text{ (mA)} \times 8.97 \text{ (s)} = 1345.5 \text{ (mA • s)} \qquad (2)$$

Whereas in the first preferred embodiment, the time required for checking the representative frequency in step S11 is found to be 1.14 seconds by the following equation (3).

$$38 \times 30 \text{ (ms)} = 1.14 \text{ (s)} \qquad (3)$$

Then, when the measured received signal strength indicators of representative frequencies $F_{15}$, $F_{16}$, and $F_{17}$ are decided to be higher than a predetermined electric field level in step S13, step S14 is performed with respect to the 112th frequency $f_{112}$ to the 135th frequency $f_{135}$. The time required only for the check in step S14 is found to be 0.72 seconds by the following equation (4).

$$8 \times 3 \times 30 \text{ (ms)} = 0.72 \text{ (s)} \qquad (4)$$

The time required for checking the representative frequencies in the frequencies to be processed in step S14 is already obtained in step S11. With use of this, the time required only for the check in step S14 is found to be 0.63 seconds by the following equation (5).

$$0.72 \text{ (s)} - 3 \times 30 \text{ (ms)} = 0.63 \text{ (s)} \qquad (5)$$

Accordingly, in accordance with the first preferred embodiment, the total time required only for the check in the band search processing can be reduced to 1.77 seconds. This is about one fifth the conventional processing time of 8.97 seconds, thereby reducing the sum of power consumption to about one fifth.

Increasing the number of frequencies per group decreases the number of groups and facilitates to decrease the number of representative frequencies, thereby further reducing the time required for step S11. As described in the foregoing, high received signal strength indicator is obtained in the band width of before and after 2.5 MHz in the vicinity of the frequency on which an effective wave is present. The sending frequency from the base station is set at predetermined intervals (200 kHz in this preferred embodiment). The differences in the number of frequencies constituting the respective groups cause inevitable differences in the band widths of the respective groups. It is therefore undesirable that the number of frequencies per group be so many that the band width of the group is over 2.5 MHz. That is, the number of frequency per group is preferably set to not more than one half the band width in which the received signal strength indicator of the frequency on which an effective wave is present is over a predetermined threshold value. The first preferred embodiment illustrates the instance that the band widths of all the groups except for the 38th group $G_{38}$ are set to 1.6 MHz (<2.5 MHz). Of course, the groups may have different band widths.

As discussed above, the first preferred embodiment enables to reduce the band search processing time and thus reduce the time required from the power-on to the completion of acceptance, thereby suppressing power consumed outside the area.

In the case that the decision based on the first condition is made by the absolute value of an RSSI, the following method may be employed. Every time a representative frequency satisfying the first condition is obtained in the check of representative frequencies, the check in step S14 is performed with respect to all the frequencies in the group to which the representative frequency belongs. For instance, in the above-mentioned example, the followings are performed. Firstly, the check in step S11 is performed with respect to the representative frequencies $F_1$ to $F_{15}$, and then the check in step S14 is performed with respect to the 112th frequency $f_{112}$ to the 119th frequency $F_{119}$. Secondly, the check in step S11 is performed with respect to the representative frequency $F_{16}$, and then the check in step S14 is performed with respect to the 120th frequency $f_{120}$ to the 127th frequency $F_{127}$. Thirdly, the check in step S11 is performed with respect to the representative frequency $F_{17}$, and then the check in step S14 is performed with respect to the 128th frequency $f_{128}$ to the 135th frequency $F_{135}$. Lastly, the check in step S11 is performed with respect to the representative frequencies $F_{17}$ to $F_{38}$ and the band search processing is terminated.

Second Preferred Embodiment

The invention for achieving the second object is mainly described in a second preferred embodiment. The invention of this embodiment is realized by employing the mobile communication device, the configuration of which is shown in Fig. 1.

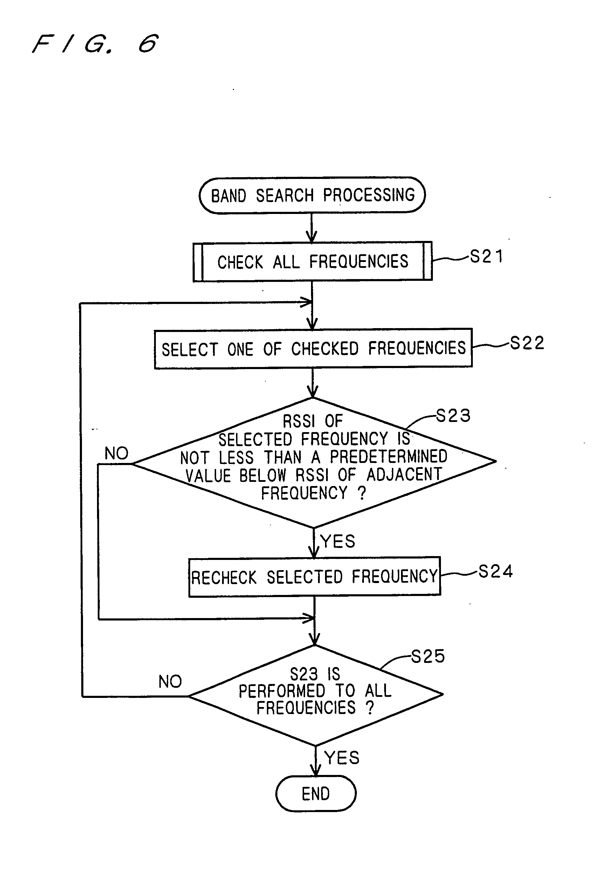

Fig. 5 is a graph showing the received signal strength indicators (RSSIs) when receiving a predetermined frequency band composed of the zero-th frequency $f_o$ to the 298th frequency $f_{298}$, which have been described in the first preferred embodiment. Fig. 5 shows only the vicinity of effective waves, that is, the 137th frequency $f_{137}$ to the 185th frequency $f_{185}$.

As stated above, the received signal strength indicator obtained in the vicinity (i.e., in the width of 5 MHz) of the frequency on which an effective wave is present is higher than that of other frequencies. Referring to Fig. 5, the received signal strength indicators of frequencies of not more than the 140th frequency $f_{140}$ and not less than the 180th frequency $f_{180}$ are constant at approximately -95 dBm. On the other hand, the received signal strength indicators of frequencies of almost all of the 141th frequency $f_{141}$ to the 179th frequency $f_{179}$ are over -95 dBm. Especially, from the 145th frequency $f_{145}$ to the 170th frequency $f_{170}$, almost all of the frequencies in a band width of about 5 MHz have a received signal strength indicator of approximately -80 dBm.

The reason for using the expression "the frequencies of almost all of the 141th frequency $f_{141}$ to the 179th frequency $f_{179}$" is that the received signal strength indicators of the frequencies in this range are not always larger than -95 dBm. For instance, the received signal strength indicators of the 142th frequency $f_{142}$ and the 175th frequency $f_{175}$ are approximately -95 dBm. Further, the reason for using the expression "from the 145th frequency $f_{145}$ to the 170th frequency $f_{170}$, almost all of the frequencies in a band width of about 5 MHz" is that even on the frequencies in this band width, some of the received signal strength indicators are considerably below -80 dBm. For instance, the received signal strength indicators of the 154th frequency $f_{154}$, the 156th frequency $f_{156}$, the 159th frequency $f_{159}$, the 160th frequency $f_{160}$, and the 164th frequency $f_{164}$ are approximately -90 dBm at the most.

In general, when the measured received signal strength indicator is low, the primary synchronization channel obtained by using this indicator has low reliability of power ratio Ec/Io. Therefore, if there are effective waves on the frequencies having received signal strength indicators lower than a predetermined electric field level, e.g., -85 dBm, the power ratio Ec/Io is calculated to be low, and there is a high possibility of deciding that no effective waves are present. In other words, the decision of the presence or absence of effective waves should be placed in pending with respect to such a frequency that an index based on the measured received signal power is lower than a predetermined value.

However, it cannot be considered that in the band width in the vicinity of the frequency on which an effective wave is present, the adjacent frequencies have widely different received signal strength indicators although there may be a gentle distribution. Accordingly, it can be considered that the received signal strength indicators of the adjacent frequencies are widely different due to accidental factor such as phasing.

The second preferred embodiment avoids failing to check the presence or absence of effective waves, by measuring again the frequencies whose received signal strength indicators seem to be lowered due to accidental factor. Following is a specific procedure.

Fig. 6 is a flowchart showing a band search processing in the second preferred embodiment. In step S21, with respect to all the frequencies $f_0$ to $f_{299}$, it is checked whether they satisfy first and second conditions. Here, the first and second conditions described in the first preferred embodiment can be used as the first and second conditions in step S21. The check based on the second condition can be omitted in a modification to be described hereinafter.

In step S22, one of the checked frequencies is selected. In step S23, it is decided whether the received signal strength indicator of the selected frequency is not less than a predetermined value below the received signal strength indicator of the adjacent frequency. The predetermined value is 5 dB, for example. From Fig. 5, with respect to the 142th frequency $f_{142}$, the 154th frequency $f_{154}$, the 156th frequency $f_{156}$, the 159th frequency $f_{159}$, 160th frequency $f_{160}$, the 164th frequency $f_{164}$, the 171th frequency $f_{171}$, the 173th frequency $f_{173}$, and the 175th frequency $f_{175}$, a positive decision can be obtained in step S23.

If a positive decision is obtained in step S23, it goes to step S24, and the frequency is rechecked. Checks based on the first and second conditions are also performed in the recheck in step S24. At this time, the check based on the first condition can be omitted in step S24, and the check based on the second condition can be omitted in the following modification. Then, it goes to step S25. Even if a negative decision is obtained in step S23, it goes to step S25.

In step S25, it is decided whether step S23 is performed with respect to all the frequencies. If a negative decision is obtained, it returns to step S22. If a positive decision is obtained, the band search processing is terminated.

As discussed above, once a certain frequency has a low indicator, the frequency is recovered and handled as the object to be decided based on the second condition, by finding its indicator again in steps S23 and S24. This avoids failing to select frequencies due to accidental factor.

Since the ground of the decision in step S23 is the received signal strength indicator, the decision in step S23 can be performed even when the check in step S24 is performed only based on the first condition. Therefore, it is possible to use such a modification of deciding only based on the first condition in step S21 and S24. In this instance, the decision based on the second condition can be made for example before the completion of the band search processing and after step S25. In order to reduce the time required for frequency scanning, the decisions based on the first and second conditions are preferably performed concurrently because the received signal strength indicator and received signal code power serving as the ground of the first and second conditions can be obtained quickly when measuring a single frequency.

Although in the foregoing description, an RSSI is used as the index based on the received signal power, the received signal code power RSCP or power ratio Ec/Io can also be used.

Communication devices employing the band search processing in the foregoing preferred embodiments, such as mobile communication devices, e.g. a receiver, can enjoy the merit of the band search processing.

While the invention has been shown and described in detail, the foregoing description is in all aspects illustrative and not restrictive. It is therefore understood that numerous modifications and variations can be devised without departing from the scope of the invention.

## Claims

**1.** A frequency selection method of selecting at least one of plural frequencies constituting a predetermined frequency band,

said plural frequencies being divided into plural groups adjacent each other in their ascending order,

at least one representative frequency being present among said plural frequencies constituting each of said groups,

said method comprising the steps of:

(a) obtaining said representative frequency satisfying a first condition on the basis of a received signal strength indicator; and
(b) selecting said at least one of said plural frequencies satisfying a second condition on the basis of the power of a desired wave, from all of said frequencies constituting each of said groups to which said representative frequency satisfying said first condition belongs.

2. The frequency selection method according to claim 1, wherein
said first condition is the fact that said received signal strength indicator is absolutely or relatively higher than a predetermined level.

3. The frequency selection method according to claim 1, wherein
said second condition is the fact that the ratio of the received energy per PN chip of a primary synchronization channel to the total received power is larger than a predetermined value.

4. The frequency selection method according to one of claims 1 to 3, wherein
each band width of said groups is set so as to be not more than one half such a band width that said received signal strength indicator is absolutely or relatively larger than a predetermined threshold value in the vicinity of said frequency on which an effective wave is present.

5. The frequency selection method according to one of claims 1 to 4, wherein
said representative frequency is obtained by selecting one frequency in a vicinity of median of a frequency band in each of said groups to which said representative frequency belongs.

6. The frequency selection method according to one of claims 1 to 5, wherein
said step (b) has the steps of:

(b-1) checking whether said representative frequency satisfies said first and second conditions; and
(b-2) checking whether all of said frequencies, except for said representative frequency, in said group to which said representative frequency satisfying said first condition belongs, satisfy said first and second conditions.

7. A frequency selection method of selecting at least one of plural different frequencies constituting a predetermined frequency band, said method comprising the steps of:

(a) when an index on the basis of a received power with respect to one of said frequencies is not less than a predetermined value below said index with respect to the other adjacent to said one frequency, finding again said index with respect to said one frequency; and
(b) from said frequencies satisfying a first condition on the basis of the fact that said index is not less than a predetermined value, selecting frequencies satisfying a second condition on the basis of the power of a desired wave.

8. The frequency selection method according to claim 7, wherein said index is on the basis of a received signal strength indicator.

9. The frequency selection method according to claim 8, wherein
said second condition is the fact that the ratio of the received energy per PN chip of said primary synchronization channel to the total received power is larger than a predetermined value.

10. The frequency selection method according to one of claims 7 to 9, wherein said step (b) is performed concurrently with said step (a).

F / G. 1

```
                        10
                      ┌────────────────────────┐
                      │   CONTROL PART         │
                      │                        │
                      │         ┌──────────┐   │
                      │         │  CPU     │───── 11
                      │         │  (S/W)   │   │
                      │         └──────────┘   │
                      └────────────────────────┘
                         ↑              ↓
                      ┌────────────────────────┐
                      │   BASE BAND PART        │── 20
                      │   ( F/W , H/W )         │
                      └────────────────────────┘
                         ↑              ↓
                      ┌────────────────────────┐
                      │   RADIO PART            │── 30
                      │   ( F/W , H/W )         │
                      └────────────────────────┘
                         │
                      ◁──┘──── 40
```

# F I G. 2

| Frequency | Group |
|---|---|
| 0th FREQUENCY $f_0$ | |
| 1st FREQUENCY $f_1$ | |
| ⋮ | 1st GROUP $G_1$ |
| 6th FREQUENCY $f_6$ | |
| 7th FREQUENCY $f_7$ | |
| 8th FREQUENCY $f_8$ | |
| 9th FREQUENCY $f_9$ | |
| ⋮ | 2nd GROUP $G_2$ |
| 15th FREQUENCY $f_{15}$ | |
| ⋮ | ⋮ |
| (8k-8)th FREQUENCY $f_{8k-8}$ | |
| ⋮ | k-th GROUP $G_k$ |
| (8k-1)th FREQUENCY $f_{8k-1}$ | |
| ⋮ | ⋮ |
| 288th FREQUENCY $f_{288}$ | |
| ⋮ | 37th GROUP $G_{37}$ |
| 295th FREQUENCY $f_{295}$ | |
| 296th FREQUENCY $f_{296}$ | |
| 297th FREQUENCY $f_{297}$ | 38th GROUP $G_{38}$ |
| 298th FREQUENCY $f_{298}$ | |

## F I G. 3

BAND SEARCH PROCESSING

CHECK REPRESENTATIVE FREQUENCY — S11

SELECT ONE OF CHECKED REPRESENTATIVE FREQUENCIES — S12

OBTAINED RSSI IS NOT LESS THAN ITS THRESHOLD VALUE ? — S13
NO

YES

CHECK ALL FREQUENCIES IN GROUP TO WHICH SELECTED REPRESENTATIVE FREQUENCY BELONGS — S14

S13 IS PERFORMED TO ALL REPRESENTATIVE FREQUENCIES ? — S15
NO

YES

END

EP 1 337 041 A1

F I G. 4

RSSI (dBm)

-70
-75
-80
-85
-90
-95

f0 f1 ··· f7 ···   f111  f112 ··· F15···f119 f120 ··· F16 ··· f127 f128 ··· F17 ···f135 ··· f296  f298
                                                                                            f297
FREQUENCY

G1      G15      G16      G17      G38

F I G. 5

FIG. 6

```
                    ( BAND SEARCH PROCESSING )
                                 │
                                 ▼
              ┌─┬─────────────────────────────┬─┐
              │ │    CHECK ALL FREQUENCIES     │ │──── S21
              └─┴─────────────────────────────┴─┘
                                 │
           ┌─────────────────────┤
           │                     ▼
           │  ┌──────────────────────────────────┐
           │  │ SELECT ONE OF CHECKED FREQUENCIES │──── S22
           │  └──────────────────────────────────┘
           │                     │
           │                     ▼
           │                  ╱──────╲
           │             ╱      RSSI OF      ╲  ──── S23
           │        ╱   SELECTED FREQUENCY IS    ╲
     NO    │  ◄───┤ NOT LESS THAN A PREDETERMINED ├
           │        ╲  VALUE BELOW RSSI OF ADJACENT ╱
           │             ╲     FREQUENCY ?      ╱
           │                  ╲──────╱
           │                     │ YES
           │                     ▼
           │  ┌──────────────────────────────────┐
           │  │     RECHECK SELECTED FREQUENCY    │──── S24
           │  └──────────────────────────────────┘
           │                     │
           └─────────────────────┤
                                 ▼
                              ╱──────╲
                         ╱              ╲  ──── S25
              NO    ◄───┤     S23 IS      ├
                         ╲ PERFORMED TO ALL ╱
                         ╲   FREQUENCIES ? ╱
                              ╲──────╱
                                 │ YES
                                 ▼
                            (   END   )
```

## EUROPEAN SEARCH REPORT

**European Patent Office**

**Application Number**

EP 02 02 3916

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 97 32421 A (MOTOROLA INC) 4 September 1997 (1997-09-04) * page 8, line 24 - page 9, line 3 * --- | 1,2,7,8 | H03J1/00 |
| A | US 5 711 001 A (BUSSAN ET AL.) 20 January 1998 (1998-01-20) * claim 1 * --- | 1,2,7,8 | |
| A | EP 1 056 303 A (NOKIA MOBILE PHONES LTD) 29 November 2000 (2000-11-29) ----- | | |

| TECHNICAL FIELDS SEARCHED (Int.Cl.7) |
|---|
| H03J H04Q |

The present search report has been drawn up for all claims

| Place of search | Date of completion of the search | Examiner |
|---|---|---|
| THE HAGUE | 20 May 2003 | Peeters, M |

EPO FORM 1503 03.82 (P04C01)

**ANNEX TO THE EUROPEAN SEARCH REPORT
ON EUROPEAN PATENT APPLICATION NO.**                  EP 02 02 3916

This annex lists the patent family members relating to the patent documents cited in the above-mentioned European search report.
The members are as contained in the European Patent Office EDP file on
The European Patent Office is in no way liable for these particulars which are merely given for the purpose of information.

20-05-2003

| Patent document cited in search report | | Publication date | Patent family member(s) | | Publication date |
|---|---|---|---|---|---|
| WO 9732421 | A | 04-09-1997 | US | 5751772 A | 12-05-1998 |
| | | | AU | 1845197 A | 16-09-1997 |
| | | | WO | 9732421 A1 | 04-09-1997 |
| US 5711001 | A | 20-01-1998 | CA | 2112809 A1 | 25-11-1993 |
| | | | CN | 1082786 A ,B | 23-02-1994 |
| | | | DE | 4392213 C2 | 29-04-1999 |
| | | | DE | 4392213 T0 | 09-06-1994 |
| | | | FR | 2691027 A1 | 12-11-1993 |
| | | | GB | 2274750 A ,B | 03-08-1994 |
| | | | HU | 69370 A2 | 28-09-1995 |
| | | | IT | 1261466 B | 23-05-1996 |
| | | | JP | 3196211 B2 | 06-08-2001 |
| | | | JP | 6508973 T | 06-10-1994 |
| | | | RU | 2123771 C1 | 20-12-1998 |
| | | | SE | 9400018 A | 07-03-1994 |
| | | | WO | 9323963 A1 | 25-11-1993 |
| | | | BR | 9404826 A | 15-06-1999 |
| | | | CA | 2135917 A1 | 27-10-1994 |
| | | | CN | 1104024 A | 21-06-1995 |
| | | | FR | 2705185 A1 | 18-11-1994 |
| | | | GB | 2283394 A | 03-05-1995 |
| | | | IT | 1272980 B | 01-07-1997 |
| | | | JP | 7508392 T | 14-09-1995 |
| | | | WO | 9424832 A1 | 27-10-1994 |
| EP 1056303 | A | 29-11-2000 | US | 6487399 B1 | 26-11-2002 |
| | | | EP | 1056303 A2 | 29-11-2000 |
| | | | JP | 2001016164 A | 19-01-2001 |

EPO FORM P0459

For more details about this annex : see Official Journal of the European Patent Office, No. 12/82